# EUROPEAN PATENT APPLICATION

(11) **EP 4 752 520 A1**
(43) Date of publication of application: **03.06.2026**
(21) Application number: 24383297.9
(22) Date of filing: 29.11.2024
(51) Int. Cl.: G01N 1/28, G01N 1/31, H01J 49/04, H01J 49/16, C23C 14/12

(54) **METHOD OF PREPARING A BIOLOGICAL SAMPLE BY LOW-TEMPERATURE THERMAL EVAPORATION FOR MALDI-MSI**

(71) Applicant: Universitat Rovira i Virgili, 43003 Tarragona (ES); Consorcio Centro de Investigación Biomédica, 28029 Madrid (ES)
(72) Inventor: MAHAMDI, Toufik, 43007 Tarragona (ES); XAVIER, Correig Blanchar, 43203 Reus (Tarragona) (ES); GARCIA-ALTARES Pérez, María, 43340 Montbrió del Camp (Tarragona) (ES); YANES Torrado, Oscar, 43391 Vinyols i els Arcs (Tarragona) (ES)
(74) Representative: Clarke, Modet y Cía., S.L.

(57) **Abstract**

The present application discloses a method of preparing a biological sample by low-temperature thermal evaporation, making the prepared sample highly suitable for subsequent MALDI-MSI analysis. The high vacuum pressure used in the method enables matrix evaporation at a low temperature, significantly reducing sample contamination and biological degradation during deposition, resulting in very pure matrix layers irrespective of matrix quality.

## Description

### Technical field

The present application relates to a method of preparing a biological sample by low temperature thermal evaporation.

### Background art

Since its introduction by Caprioli et al. in the late 1990s [1], mass spectrometry imaging (MSI) has become a powerful tool for analysing the spatial distribution of various molecular classes within biological tissues. Matrix-Assisted Laser Desorption/Ionization-Mass Spectrometry Imaging (MALDI-MSI) enables the visualization of compounds including proteins [2], lipids [3], metabolites and drugs [4] within tissue sections. Matrix deposition stands out as a crucial step in sample preparation, significantly impacting the quality of ion images produced. Various techniques are employed for applying matrices in tissue samples, including wet methods like spraying [5,6] and dry methods like sublimation [7,8]. Sublimation offers advantages over spraying in terms of matrix deposition homogeneity [7,9,10], analyte delocalization [11,12], and spatial resolution [7-9,13]. Sprayer devices are used for wet deposition, while sublimation devices are utilized for dry deposition.

However, current devices do not adequately address challenges like controlling matrix thickness, preventing biological degradation from elevated temperatures, and ensuring the purity of matrix deposition.

The deposition of matrix compounds significantly influences the effectiveness of matrix assisted laser desorption/ionization (MALDI) Mass Spectrometry Imaging (MSI) experiments, impacting sensitivity, spatial resolution, and reproducibility. Dry deposition methods offer advantages by producing homogeneous matrix layers and minimizing analyte delocalization without the use of solvents. However, refining these techniques to precisely control matrix thickness, minimize heating temperatures, and ensure high-purity matrix layers is crucial for optimizing MALDI-MSI performance.

In this regard, thin film deposition techniques like physical vapor deposition (PVD) and chemical vapor deposition (CVD) have been refined for precise deposition of pure and thin material layers. PVD encompasses processes like vacuum or thermal evaporation (TE), sputtering, and ion plating, which involve vaporizing atoms or molecules from a source, transporting them through a vacuum, and condensing them onto a substrate. PVD is widely used in various industries to enhance properties such as hardness and wear resistance [14-18]. In MALDI-MSI, PVD coating with gold or silver nanoparticles has been explored as an alternative to organic matrices [19,20]. TE techniques offer advantages like higher purity films and better control over film thickness [21]. Researchers have investigated factors like substrate holder geometry and vacuum pressure to enhance coating uniformity and distribution. Low temperature evaporation (LTE) has emerged as a notable advancement in vacuum evaporation techniques, particularly beneficial for organic materials sensitive to temperature variations. LTE finds applications in diverse industries, including nanotechnology, solar cells, and pharmaceuticals [22-24].

Document US9334569 describes a sample preparation device suitable for the formation of a matrix film for MALDI through vacuum vapor deposition. In contrast with the present invention, this document describes that the deposition method is carried out at sublimation temperatures of the matrix substance.

Document EP3080327 discloses an evaporation source for organic material. A method for evaporating organic material under vacuum conditions is described, however it does not provide parametric details about the deposition method. More specifically, no evaporation temperature range is provided.

Document JP2014206389 discloses a method for the pretreatment of a biological sample for investigating the distribution of medicine in a biological sample and quantifying the medicine in the biological sample using MALDI. This method is useful especially when imaging mass spectrometric analysis is performed in a clinical test. In contrast with the present invention, the document describes a method step of sublimation using a conventional vacuum deposition apparatus, aiming to create a dry matrix crystal layer on the biological tissue. Step two is spraying a matrix solution to grow the matrix crystals formed in the first step.

Document EP2975393 discloses a sample such as a biomedical tissue section attached to an electrically conductive slide glass, followed by the formation of a film layer of a matrix substance formed by vapor deposition so as to cover the sample. The deposition of the matrix material is carried out via sublimation involving high temperatures. Evidence is disclosed in the target temperature being a sublimation temperature about 130 °C in DHB.

A few thermal deposition/evaporation devices are already available on the market. However, while these devices are aimed at vapor deposition of organic substances, they seem to do so at high temperatures. In fact, some of the available devices are aligned with the scope of document US9334569, which leans towards sublimation methods of deposition at high temperatures.

### Summary

The present application relates to a method of preparing a biological sample by low-temperature thermal evaporation suitable for MALDI-MSI analysis comprising the following steps:
- Providing a biological sample;
- Providing an organic matrix compound in the form of a powder;
- Providing a pressure condition between 5x10⁻³ and 5x10⁻⁵ Pa;
- Providing a temperature condition by heating the organic matrix compound at a temperature between 50°C and 60°C, and increasing the temperature in 5°C, or 2°C, or 1°C increments until reaching the evaporation temperature of the matrix compound at the set pressure;
- Waiting for at least 2 minutes for deposition rate stabilization;
- Rotating the biological sample to allow the deposition of at least one matrix layer on the surface of the sample;
- Monitoring the thickness of the deposited matrix compound layer on the biological sample until the desired thickness is achieved;
- Collecting the biological sample with at least one organic matrix layer suitable for MALDI-MSI analysis.

In one embodiment, the organic matrix compound is selected from 2,5-dihydroxybenzoic acid, 1,5-Diaminonaphthalene, 9-Aminoacridine, α-Cyano-4-hydroxycinnamic acid, Sinapinic acid or α-Cyano-4-hydroxycinnamic acid and Aniline.

In one embodiment, the method is carried out in a thermal evaporation device suitable for the deposition of volatile compounds up to 600°C, the device comprising a rotary sample holder, at least one low thermal evaporation source, at least one source shutter, at least one substrate shutter, at least one quartz crystal thickness sensor.

In one embodiment, the source and substrate shutters of the device are closed during the temperature increasing phase of the method.

In one embodiment, after the evaporation temperature of the organic matrix compound is reached, the source and substrate shutters of the device are opened.

### General description

The purpose of the present invention is to provide an alternative and improved method for the dry deposition of organic matrix compounds. The method herein disclosed is particularly suitable for organic matrix deposition in biological samples for subsequent MALDI-MSI analysis. The disclosed method takes advantage of a PVD technique, i.e., low temperature evaporation under reduced vacuum pressure, to obtain a reproducible control of matrix layer thickness and produce pure layers, thus achieving enhanced ionization, reduced analyte diffusion, and improved MSI image quality.

The disclosed method aims to provide improvements in the deposition of an organic matrix compound as a thin layer on a biological sample to be subsequently analysed by MALDI-MS. Further, the method also aims to improve the quality of the matrix-deposited sample and therefor the imaging outcome.

The LTE technique used in the presently disclosed method is essentially distinct from sublimation and spray techniques currently seen in the prior art for the same purpose of matrix deposition. The emphasis on maintaining low temperatures throughout the evaporation process is a key aspect in the present invention.

Since the method is carried out at significantly lower temperatures in comparison to prior art, it prevents the desorption of impurities on the target sample. The high-vacuum pressure (<5x10⁻³ Pa) and low evaporation temperatures were proven to significantly reduce sample contamination and biological degradation during deposition, resulting in very pure matrix layers irrespective of matrix quality.

Another effect of the disclosed method, includes the precise control of matrix thickness, yielding homogeneous layers of small-sized matrix crystals with controlled morphology and size for a broader range of matrices. The matrices deposited via this method remained stable when stored at -80°C with no impact on ionization efficiency or image quality. For comparison, other methodologies such as spray deposition don't show this level of matrix stability after deposition. Overall, the method leads to higher signal intensities, reduces analyte diffusion, enhances MALDI imaging data quality, consequently resulting in clearer and more accurate analysis of biological samples.

Thus, LTE is proposed as a novel dry deposition method for applying organic matrix compounds for MALDI-MSI analysis to achieve better control over the matrix layer and ensure a high-quality, uniform matrix crystal coating.

As an example, this deposition method was applied for 2,5-dihydroxybenzoic acid (DHB), and 1,5-Diaminonaphthalene (DAN) matrices at 80°C and 5x10⁻³ Pa, and ensured controlled deposition rates while minimizing sample degradation. Environmental Scanning Electron Microscopy (ESEM) analysis confirmed the homogeneous distribution of submicrometer-sized matrix crystals over tissue samples. Notably, using <99% pure matrices did not compromise analyte ionization or MS image quality compared to >99% pure matrices. Tissue sections coated with DAN or DHB matrix stored at -80°C for 2 weeks yielded consistent MALDI-MSI results. Comparisons with the traditional spray-coating method demonstrated LTE's superiority in detecting more analytes, yielding higher signal intensities, and producing higher-quality MALDI images with reduced analyte diffusion.

For comparison, in sublimation, the temperature is set at the evaporation temperature to start depositing on the target sample, which causes evaporation of the matrix sample and the impurities. However, in the presently disclosed method by setting the temperature at a lower value (between 50-60°C), and performing a temperature increase phase with increments of 5°C, or 2°C or 1°C until the evaporation temperature of the matrix is reached, the impurities that have lower evaporation temperature are evaporated and deposited but since the shutters of the suitable thermal evaporation device are closed, it is possible to prevent said impurities from reaching the biological sample. Therefore, when reaching the targeted evaporation temperature of the chosen matrix, it is expected that only the matrix particles are deposited on the biological sample. Consequently, the disclosed method can also be seen as a manner to purify the organic matrix compound during the deposition phase, which is an effect that is unattainable with the tradition sublimation or spray deposition methods disclosed until now.

Thus, the disclosed method ensures that only the purified matrix reaches the biological sample, significantly reducing the risk of contamination from lower-temperature impurities. The result is a homogenous and highly pure matrix layer on the sample, which is critical for achieving high-quality and reproducible MALDI-MSI results. This meticulous approach to matrix purification through temperature control and relying on a shutter system is a defining feature of this LTE method, setting it apart from sublimation and spray deposition techniques in the prior art.

### Brief description of drawings

For easier understanding of this application, figures are attached that represent the preferred forms of implementation which nevertheless are not intended to limit the technique disclosed herein.

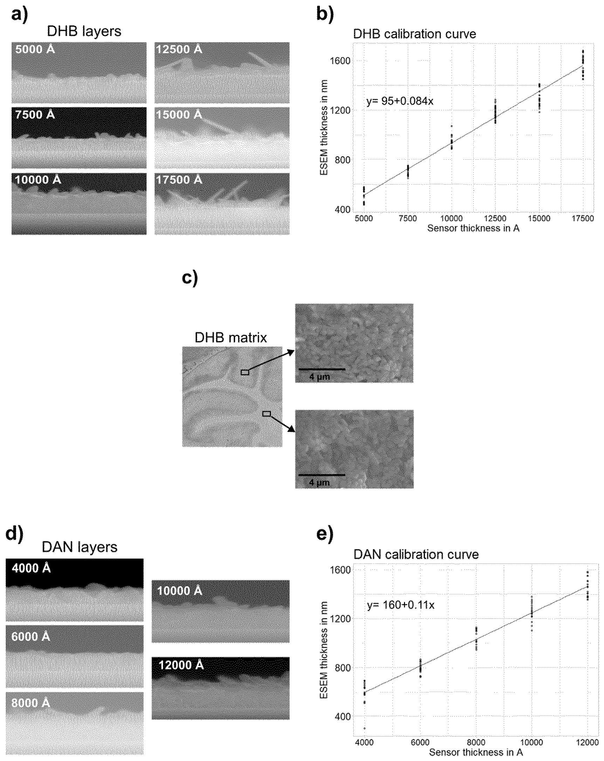

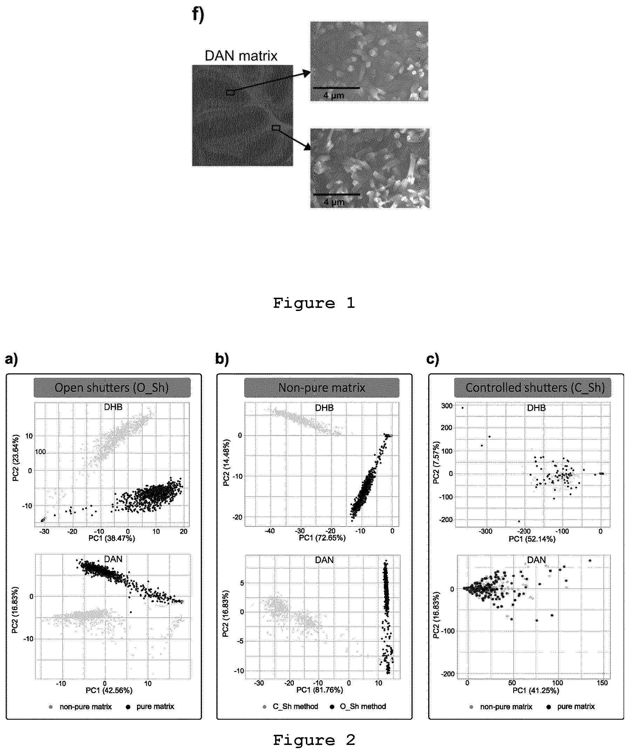

Figure 1 shows: a) cross-section ESEM images of six layers of DHB (5,000 to 17,500 Å monitored by the quartz sensor). b) Calibration curve depicting the deposition of DHB, showing the relationship between the sensor thickness reported in angstrom units and the real thickness measured by ESEM in nanometers. c) Microscopy image of a mouse cerebellum tissue coated with DHB matrix (left) with corresponding ESEM images of a DHB surface layer acquired at 10,000 magnifications from the grey matter region (top right) and the white matter region (bottom right). d) cross-section ESEM images of five layers of DAN (4,000 to 12,000 Å monitored by the quartz sensor). e) Calibration curve illustrating the deposition of DAN, indicating the correlation between the sensor thickness reported in angstrom units and the real thickness measured by ESEM in nanometers. f) Microscopy image of a mouse cerebellum tissue coated with DAN matrix (left) with related ESEM images of a DAN surface layer acquired at 10,000 magnifications from the gray matter region (top right) and the white matter region (bottom right). Scale bar, 4 µm.

Figure 2 shows the deposition of pure and non-pure DHB (top) and DAN (bottom) matrices, using the open shutters (O_Sh) or controlled shutters (C_Sh) protocol, and related data from MALDI-MSI of only matrix, a) principal components analysis (PCA) plots of principal components 1 vs. 2 acquired using Open shutters protocol, showing separation between non-pure and pure matrices. b) PCA plots of principal components 1 vs. 2 acquired using non-pure matrices with controlled shutters vs. open shutters, c). PCA plots of principal components 1 vs. 2 acquired using the controlled shutters protocol, illustrating overlapping between non-pure and pure samples.

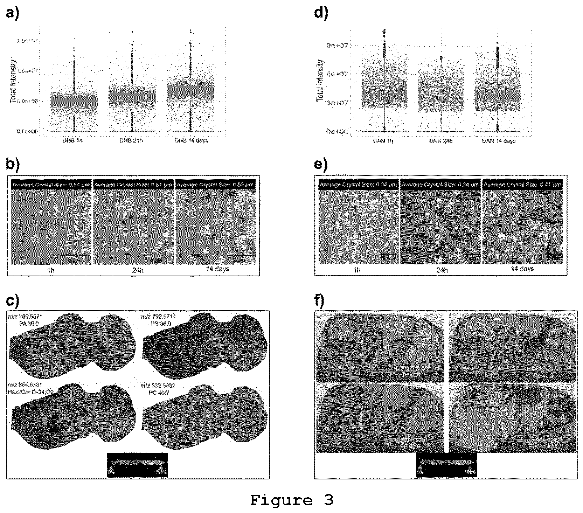

Figure 3 shows: a) Boxplot showing the total ion count (TIC) intensity from mouse brain coated with DHB after storage at -80°C for 1 hour, 24 hours, and 14 days. b) ESEM images of the DHB surface layer after storage durations of 1 hour, 24 hours, and 14 days; scale bar: 2 µm. c) MSI images of four intact lipids acquired at 20 µm lateral resolution from mouse brain coated with DHB matrix, using MALDI-Orbitrap mass spectrometer: PA 39:0 (m/z 769.5671, [M+Na]+), Hex2Cer 34:0;O2 *(m*/*z* 864.6381, [M+H]+), PS 36:0 (m/z 792.5714, [M+H]+), PC 40:7 (m/z 832.5885, [M+H]+). d) Boxplot representing the TIC intensity from mouse brain coated with DAN after storage at -80°C for 1 hour, 24 hours, and 14 days. e) ESEM images of the DAN surface layer after storage durations of 1 hour, 24 hours, and 14 days; scale bar: 2 µm. f) MSI images of four intact lipids acquired at 10 µm lateral resolution from mouse brain coated with DAN matrix, using timsTOFfleX mass spectrometer: PI 38:4 (m/z 885.5443, [M-H]-), PE 40:6 (*m*/*z* 790.5331, [M-H]-), PS 42:9 (m/z 856.5070, [M-H]-), PI-Cer 42:1 (*m*/*z* 906.6282, [M-H]-).

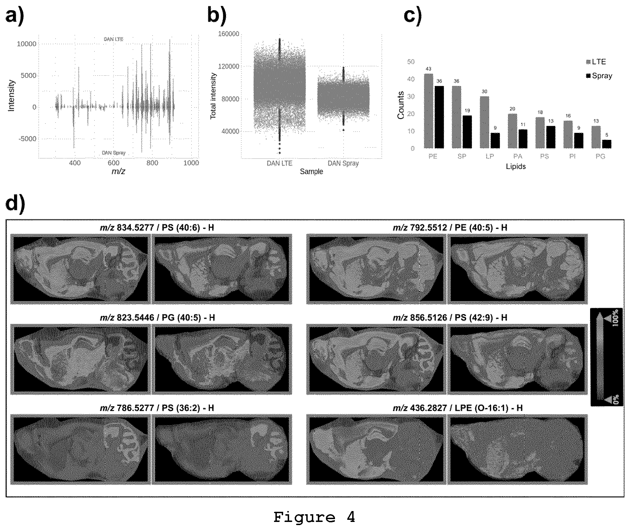

Figure 4 shows MALDI-MSI analysis of mouse brain tissue coated with DAN matrix using LTE deposition and spray deposition. a) Average spectra comparison, b) Boxplots representing the intensity of the total ion count (TIC) for each deposition method. c) Bar plot illustrating the number of annotated lipid species detected using LTE, spray method. d) MSI images acquired at 30 µm lateral resolution, depicting six intact lipid ions: PS 40:6 (m/z 834.5277), PE 40:5 (*m*/*z* 792.5512), PG 40:0 (m/z 823.5446), PS 42:9 (*m*/*z* 856.5126), PS 36:2 (*m*/*z* 786.5277), and LPE O-16:1 (m/z 436.2527). All lipid ions were detected in negative mode ([M-H]⁻). Images obtained using LTE and spray techniques are show.

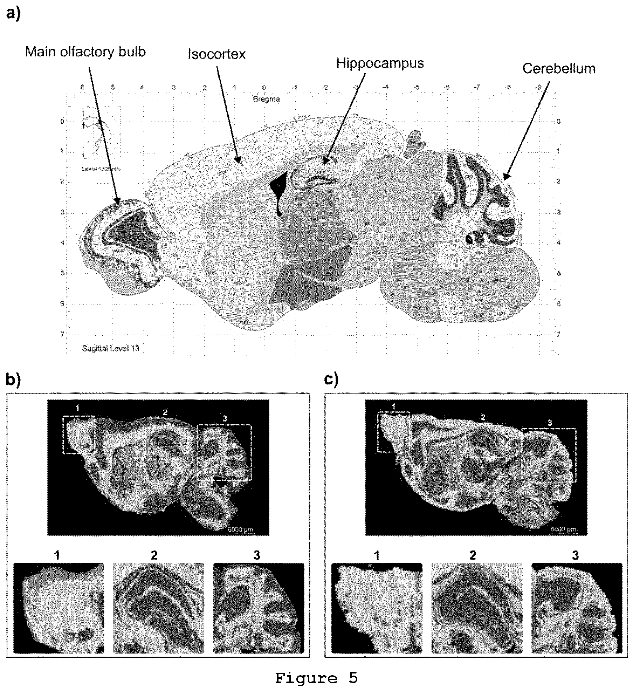

Figure 5 shows: a) Anatomical reference atlas displaying sagittal mouse brain structures with a systematic, hierarchically organized taxonomy [29]. b) Segmentation outcomes of sagittal mouse brain tissue coated with DAN matrix using LTE deposition (top) with zoom-in images of the main olfactory bulb (b1), hippocampus (b2), and cerebellum (b3) regions. c) Segmentation results of sagittal mouse brain tissue coated with DAN matrix using LTE deposition (top) with zoom-in images of the main olfactory bulb (b1), hippocampus (b2), and cerebellum (b3) regions. Number of clusters=6; scale bar: 6000 µm.

### Detailed description of embodiments

Now, preferred embodiments of the present application will be described in detail with reference to the annexed drawings. However, they are not intended to limit the scope of this application.

Method of preparing a biological sample by low-temperature thermal evaporation suitable for MALDI-MSI analysis comprising the following steps:
- Providing a biological sample;
- Providing an organic matrix compound in the form of a powder;
- Providing a pressure condition between 5x10⁻³ and 5×10⁻⁵ Pa;
- Providing a temperature condition by heating the organic matrix compound at a temperature between 50°C and 60°C, and increasing the temperature in 5°C, or 2°C or 1°C increments until reaching the evaporation temperature of the matrix compound at the set pressure;
- Waiting for at least 2 minutes for deposition rate stabilization;
- Rotating the biological sample to allow the deposition of at least one matrix layer on the surface of the sample;
- Monitoring the thickness of the deposited matrix compound layer on the biological sample until the desired thickness is achieved;
- Collecting the biological sample with at least one organic matrix layer suitable for MALDI-MSI analysis.

In one embodiment, the biological sample is selected from, but not limited to, a biological tissue collected from a mammalian organ, plants, bacterial cultures, or algae. For sake of clarity, the biological samples are those that can be sectioned with a cryostat.

In one embodiment, the matrix compound is selected from, but not limited to, 2,5-dihydroxybenzoic acid (DHB), 1,5-Diaminonaphthalene (DAN), 9-Aminoacridine (9AA), α-Cyano-4-hydroxycinnamic acid (CHCA), Sinapinic acid (SA) or CHCA-ANI. The matrix compound is appropriately selected according to the characteristics of the biological sample to be analysed by MALDI-MSI.

Table 1 shows an example of the organic matrix compounds suitable for the described method and their evaporation temperatures at 5x10⁻³ Pa.

**Table 1. Matrix evaporation temperatures at 5x10⁻³ Pa.**

| **Matrix compound** | **Evaporation temperature (°C)** |
|---|---|
| 2,5-dihydroxybenzoic (DHB) | 80 |
| 9-Aminoacridine (9AA) | 105 |
| 1,5-Diaminonaphthalen (DAN) | 80 |
| α-Cyano-4-hydroxycinnamic acid (CHCA) | 100 |
| Sinapinic acid (SA) | 94 |
| α-Cyano-4-hydroxycinnamic acid (CHCA) and Aniline (ANI) (CHCA-ANI) | 110 |

The disclosed method starts at a controlled temperature between 50 and 60°C, which is gradually increased in increments of 5°, 2° or 1°C depending on the chosen matrix compound. This temperature increasing phase of the method continues until reaching the evaporation temperature of the chosen matrix at the pressure that was initially set.

Once the evaporation temperature is reached, there is a characteristic spike in the deposition rate, and after a stabilization time, the deposition rate becomes steady. Once the temperature is stabilized, the deposition phase starts.

Sample rotation during the deposition phase of the method ensures a homogeneous distribution of the deposited organic matrix compound across the biological sample, thus improving the quality of the final product.

In one embodiment, the thickness of the organic matrix layer is measured in Angstrom (Å).

In one embodiment, the method is carried out in a thermal evaporation device suitable for the deposition of volatile compounds up to 600°C.

In one embodiment, the thermal evaporation device comprises a rotary sample holder, at least one low thermal evaporation source, at least one source shutter, at least one substrate shutter, at least one quartz crystal thickness sensor.

In one embodiment, the source and substrate shutters are closed during the temperature increasing phase of the method. This ensures that any impurities of the organic matrix compound, which typically evaporate at lower temperatures, are effectively removed without coming into contact with the biological sample, thus contributing to the improved quality of the biological sample after deposition.

In one embodiment, after the evaporation temperature of the organic matrix compound is reached, the source and substrate shutters are opened. The shutters remain open during the deposition phase of the method. This allows the organic matrix compound to be deposited in the biological sample in a highly controlled and purified form.

In one embodiment, the biological sample is provided in a sample substrate holder arranged facing down in the device chamber.

In one embodiment, the biological sample is provided on a surface, for example a microscope slide, and placed on the sample holder.

In one embodiment, the pressure is reduced inside the device chamber.

In one embodiment, the temperature is reduced below 100°C and pressure returned to atmospheric pressure prior to collecting the biological sample with at least one organic matrix layer suitable for MALDI-MSI analysis.

In the method disclosed above, the high-pressure and low temperature condition for depositing the matrix compound allows to vaporize the organic matrix compound and achieve enhanced ionization, reduced analyte diffusion, and improved MSI image quality.

For sake of completeness, the method of preparing a biological sample by low-temperature thermal evaporation carried out in a thermal evaporation device comprising source and substrate shutters, can comprise the following steps:
- Providing a biological sample in the device chamber;
- Providing an organic matrix compound in the form of a powder in the device chamber;
- Providing a pressure condition between 5x10⁻³ and 5×10⁻⁵ Pa in the device chamber;
- Closing the source and substrate shutters;
- Heating the organic matrix compound at a temperature between 50 and 60°C and increasing the temperature in 5°C, or 2°C or 1°C increments until reaching the evaporation temperature of the matrix compound at the set pressure;
- Waiting for at least 2 minutes for deposition rate stabilization at the set evaporation temperature;
- Opening the source and substrate shutters;
- Rotating the biological sample to allow the deposition of at least one matrix layer on the surface of the sample;
- Monitoring the thickness of the deposited matrix compound layer on the biological sample until the desired thickness is achieved and then closing the source and substrate shutters;
- Lowering the temperature to 0°C and venting the device chamber;
- Collecting the biological sample with at least one organic matrix layer suitable for MALDI-MSI analysis.

### Control and reproducibility of matrix layer thickness by low-temperature thermal evaporation

Given the lack of prior research on LTE-based organic matrix deposition for MALDI-MSI, the initial aim was to determine the optimal evaporation temperature for matrices DHB and DAN, which were found to be 80°C under a vacuum pressure of 5x10⁻³ Pa. By opening the thermal evaporation device shutters at this temperature, only evaporated matrix particles reached the sample substrate. Unlike sublimation methods requiring higher temperatures (120-140°C for DHB [7,8] and 110-140°C for DAN [8,25]), the currently described method minimized the introduction of volatile impurities and reduced the risk of analyte degradation in biological tissues.

The thickness of the matrix layer is a critical parameter in MALDI imaging experiments as it determines the migration efficiency of analyte molecules through the sample to the matrix layer surface. Hence, the primary aim was to develop a reproducible deposition method capable of controlling the deposited matrix thickness. A thickness sensor integrated into the thermal evaporation device relied on the density and acoustic number of the deposited material to calculate thickness in angstroms (Å). Following the method, a six-layer thicknesses of DHB was deposited ranging from 5,000 to 17,500 Å and five-layer thicknesses of DAN ranging from 4,000 to 12,000 Å.

Environmental Scanning Electron Microscopy (ESEM) images depicted in Figure 1a illustrate the characteristics of six different DHB layers. Notably, the deposition of DHB resulted in homogeneous layers with a sparse distribution of small crystals at the surface up to a monitored thickness of 10,000 Å. However, beyond this threshold, the number of matrix crystals increased proportionally with the monitored layer thickness, becoming more pronounced from 12,500 Å onwards. Conversely, the application of DAN matrix using LTE deposition yielded very homogeneous layers with smaller crystals at the surface (Figure 1d) compared to DHB. Furthermore, observations from ESEM images indicated that the matrix layer thickness reached a point of saturation at approximately 12,500 Å for DHB and 10,000 Å for DAN. Beyond these thresholds, additional deposited particles led to the formation of more crystals on the surface rather than contributing to the matrix layer.

Moreover, three different targeted thicknesses were deposited on the same day, and six replicates were applied on different days for each calibration point. Results demonstrated that the LTE method described herein can produce highly repetitive and reproducible matrix layers with low standard deviation. Additionally, the calibration curves of DHB (y=95+0.084x) and DAN (y=160+0.11x) matrices were calculated, where the real thickness measured by ESEM (y) exhibited a linear relationship with the sensor-monitored thickness (x) for both matrices, showing strong correlation coefficients (R²=0.99) (Figure 1b and 1e).

Calibration curves were also derived for the deposited matrix weight (µg/cm²), resulting in equations y= 13+0.013x for DHB and y= 6.7+0.013x for DAN.

### Matrix crystal formation

The matrix crystals formed by LTE deposition of DHB and DAN matrices onto mouse brain tissue were also investigated. Representative ESEM images of the DHB surface layer at the grey and white matter parts of the brain cerebellum are depicted in Figure 1c, while Figure 1f showcases the morphology of DAN crystals on the surface layer of the coated cerebellum grey and white matter. These images reveal a homogeneous distribution of DHB and DAN crystals across the matrix surface layer.

Simultaneously, the homogeneity of the matrix layer deposited by LTE onto silicon slides was also explored. Nine thickness measurements were acquired from different areas of the silicon slide coated with 240 µg/cm² of DHB matrix, yielding an average thickness of 1609.22 nm. Notably, the standard deviation across the slide was as low as 2.54%. These results underscore the capability of LTE deposition to produce a very uniform matrix layer with a homogeneous distribution of matrix crystals over the surface layer.

Apart from the homogeneous distribution of matrix crystals over the surface layer, the size of these crystals also significantly impacts MALDI-MSI performance, as it can influence ionization efficiency. Larger crystals require higher laser power for ionization compared to smaller crystals [26]. Utilising ESEM, the size of DAN and DHB crystals deposited by the LTE method was calculated, revealing small DAN crystals with an average size of 0.34 µm and a standard deviation of 18.17%, while DHB matrix produced crystals with an average of 0.54 µm and a standard deviation of 23.36%. In the context of current advancements towards single-cell imaging [27,28] with pixel sizes as small as 1-2µm[2], LTE technique represents a significant advancement in matrix deposition for MALDI-MSI applications.

### Influence of LTE and deposition method on matrix purity for MALDI MSI

The efficacy of LTE combined with controlled source shutters during matrix evaporation was investigated to prevent the deposition of volatile impurities into tissue samples, thereby enabling the utilization of less pure matrices for MALDI-MSI studies. To this end, two types of DHB and DAN matrices differing in purity (non-pure <99% versus pure >99%) on empty glass slides were deposited using two distinct deposition protocols: controlled shutters (C_Sh) versus open shutters (O_Sh). The controlled shutters protocol entails maintaining the shutters closed until the evaporation point of the matrix is reached, whereas the second protocol involves opening both the source and substrate shutters from the onset of deposition, allowing all evaporated particles from the organic matrix material to deposit on the substrate. After MALDI-MSI analysis, principal components analysis (PCA) was employed to discern how the purity of the matrix and the deposition protocol influence the variance in the data (Figure 2), with each point representing a pixel from either sample. Approximately 2000 pixels were acquired per sample, and 1000 random pixels were selected for data analysis. When the shutters were left open during the deposition process (Figure 2a), the second principal component (PC2) effectively separated the two matrices for both DHB and DAN, with the primary variance in the dataset (approximately 40%) attributed to the purity of the matrix. In this scenario, the initial heating of the evaporator source containing the matrix to 55°C, gradually increasing to 80°C, may lead to the evaporation of volatile impurities with temperatures different from 80°C, consequently depositing impurities onto the substrate sample.

Subsequently, the performance of non-pure DHB and non-pure DAN matrices was evaluated using both the controlled shutter and open shutter approaches (Figure 2b), which exhibited separation by PC1 (explaining over 70% of the variance). As the same matrix purity was initially used for evaporation, the variance between the two groups stemmed from the deposition protocol. Finally, pure and non-pure DHB and DAN matrices were deposited using the presently disclosed deposition method with controlled shutters (Figure 2c). Notably, an overlap of the two samples (non-pure and pure matrices) was observed, indicating no differences between the two measured matrix sections. Unlike the open shutters protocol, opening the substrate shutters for matrix deposition when chamber temperatures reached 80°C effectively blocked other volatile impurities at temperatures below 80°C, preventing the desorption of impurities with temperatures higher than 80°C.

In summary, utilizing shutters to control when the matrix deposits on the sample allows the use of non-pure DHB and DAN matrices (approximately ten times cheaper than pure matrices) with comparable results.

Subsequently, the impact of matrix purity was assessed using the presently disclosed deposition method with controlled shutters on MALDI-MSI analysis of biological tissues. To this end, the results of MALDI imaging of lipids from mouse brain sections were compared when utilizing pure and non-pure DHB or DAN matrices. This experiment was replicated three times. Pooling all the results, the use of less pure matrices did not compromise lipid analytes ionization. Moreover, it preserved the high-resolution quality of the ion images when compared to those obtained from the pure matrices. This finding underscores the robustness and reliability of the disclosed method with shutters in maintaining the integrity and effectiveness of MALDI-MSI analysis, irrespective of matrix purity.

### Optimization and stability of LTE-deposited matrix layers for MALDI-MSI of brain tissue lipids

Initially, the matrix layer thickness for MALDI-MSI of lipids from mouse brain tissue was optimized. Using the calibration curves, the thicknesses of 1.36 µm for DHB and 1.26 µm for DAN was identified as optimal layers, providing stronger signals for intact lipids while minimizing matrix self-ionization.

Next, the stability of tissue samples coated with LTE-deposited matrix when stored at -80°C was investigated. Consecutive mouse brain sections coated with DHB and DAN matrices were stored for 1 hour, 24 hours, and 14 days prior to MALDI-MSI analysis. Comparative analysis of the total ion counts (TIC) in each pixel from cerebellum brain sections at different time points is presented in Figure 3a and 3d. For both DHB and DAN matrices, stable analyte ionization was observed over the two-week storage period, as evidenced by comparable TIC and consistent average spectra. ESEM images of DHB and DAN matrices showed consistent small crystal distribution across storage periods of 1 hour, 24 hours, and 2 weeks, with stable average sizes (DHB: 0.54 µm; DAN: minor increase from 0.34 µm to 0.41 µm after two weeks) (Figure 3b and 3e). This stability was confirmed by MALDI-MSI results, which demonstrated identical lipid ion distribution patterns and comparable signal intensities across all storage durations.

To reinforce these findings, high-resolution MALDI-MSI of mouse brain tissue was performed using DHB and DAN matrices after storing the tissue at -80°C for 15 and 23 days, respectively. Analysis with MALDI-Orbitrap and timsTOF flex equipment revealed exceptional image quality at resolutions of 20 µm and 10 µm, respectively, showcasing distinct lipid distribution patterns in various brain regions (Figure 3c and 3f). These results affirm that storing tissue coated with LTE-deposited matrices at -80°C preserves ionization efficiency and image quality, even at high spatial resolutions, indicating the robustness of LTE-deposited matrices over time.

The thermal evaporation device substrate holder accommodated three microscopic slides, enabling simultaneous matrix deposition onto three tissue slides in one run. Importantly, it was found that tissue slide positioning on the substrate area did not affect MALDI-MSI results. This stability of coated tissue samples at -80°C not only streamlines the experimental workflow by reducing the number of experimental depositions from three to one but also facilitates collaborative research by centralizing sample preparation and enabling the shipment of coated samples to other laboratories for MALDI-MSI acquisition if needed.

### Comparative analysis of LTE and spray-coating methods in matrix deposition and MSI image quality for MALDI-MSI of mouse brain tissue

The optimized LTE method herein disclosed was compared directly to the spray method through MALDI-MSI using timsTOF-flex on serial sections of mouse brain for both DAN and DHB matrices. While matrix application with LTE was performed one month before MSI acquisition, the spray-coating samples underwent MSI analysis immediately after matrix application. Figure 4a and 4b illustrate the comparison of representative average spectra and TIC plots for DAN matrix deposition using LTE and spray methods, respectively. In the spray-coating data, signal intensities of ions detected in the lipid mass range (*m*/*z* 600 to 1000 Da) were lower compared to those obtained from LTE deposition. The TIC, representing the sum of ions detected in each pixel, showed an improvement with the LTE method over spray coating. After lipid annotation, the LTE samples revealed 176 annotated lipids, while the spray-coating method yielded 102. In Figure 4c, the lipid species annotated from mouse brain sections coated with DAN matrix are compared. Both deposition techniques exhibited high sensitivity in detecting glycerophosphoethanolamine (PE) lipid class, with 43 and 36 PE lipids annotated from LTE and spray-coating samples, respectively. Notably, the LTE method showed greater numbers of all other detected lipid classes compared to spray-coating, particularly lysophosphatidylcholine (LP), sphingolipids (SP), and glycerophosphate (PA) species.

Furthermore, the quality of MSI images for lipid ions obtained from both deposition methods was evaluated. Using DAN deposited via LTE and spray-coating, six ion images of polar lipids from the sagittal mouse brain at 30 µm lateral resolution (Figure 4d) were presented. The MSI images from the LTE sample displayed clearer and sharper features compared to those from the spray-coating method. Notably, LTE deposition exhibited less lipid diffusion, evident in the pattern distribution of lipids such as PS 40:6 (*m*/*z* 834.5277), PE 40:5 (*m*/*z* 792.5512), and PS 42:9 (*m*/*z* 856.5126). In contrast, spray-coating resulted in lipid diffusion from the cerebellum and cerebral cortex towards the brain section periphery. Conversely, LTE delineated brain regions more clearly, including the molecular layer and granular layer of the cerebellum, emphasized by the distribution of lipid PS 42:9 (*m*/*z* 856.5126). This distinction was challenging with spray-coating due to analyte diffusion and delocalization. Furthermore, the distribution of lipid PS 36:2 (*m*/*z* 786.5277) highlighted the cerebellum's structure, showing a homogeneous distribution with LTE deposition, unlike spray-coating, which exhibited varying abundances within the layer. MSI images obtained using spray-coating were blurred for low molecular weight lipids like LPE (*m*/*z* 436.2527), whereas LTE showed improved clarity and better-defined brain regions, such as the hippocampus.

To objectively quantify the quality of MSI images, two aspects were evaluated: the dispersion of intensity within LTE and spray-coating samples, and the accuracy of defining histological mouse brain regions using image segmentation. Focusing on a comparable cerebellum region in both images, represented pixel intensities were represented using density plots for a selected group of ions. Specifically, considering lipid PS 36:2 (*m*/*z* 786.5277), which highlighted the cerebellum region (Figure 4d), LTE deposition exhibited improved uniformity of signal intensity within the selected pixels (sd=0.0544) compared to the spray-coating method (sd=0.1095).

Additionally, the reference mouse brain atlas (Figure 5a) was compared with the clustering outcomes of two MSI images obtained using LTE (Figure 5b) and spray-coating (Figure 5c) deposition of DAN matrix. For both methods, employing 6 clusters proved sufficient to delineate various anatomical regions of the mouse brain, including the cerebellum, hippocampus, isocortex, and the main olfactory bulb (MOB). Notably, images zoomed in using the LTE method exhibited finer structural details of the MOB (Figure 5b-1) and the hippocampus (Figure 5b-2), aligning better with the reference atlas compared to those obtained with the spray-coating method (Figure 5c-1 and 5c-2). Furthermore, segmentation of the sagittal brain coated with LTE (Figure 5b-3) showed excellent correspondence with the reference atlas, accurately delineating specific parts of the cerebellum (grey and white matter). Particularly, the molecular layer of the gray matter was distinctly defined with a single cluster (depicted in purple in Figure 5b-3). In contrast, clustering of the spray-coating image divided the molecular layer region into two clusters, with an additional yellow-coloured cluster (Figure 5c-3), inconsistent with the cerebellum's anatomical structure. Moreover, these cluster groups appeared outside the cerebellum and the isocortex region (near the edges). Similar observations were made with clustering using k=5 for the MSI image. In LTE deposition, the analyte composition of the molecular layer region remained consistent, resulting in a homogeneous cluster. Conversely, the presence of two cluster groups in spray-coating results could be attributed to analyte diffusion and delocalization caused by the spray-coating method.

The presently disclosed novel dry deposition method with low-temperature thermal evaporation proved to be a precise and reproducible application of thin organic matrices in MALDI-MSI. This approach offers several advantages over existing methods. The high vacuum pressure achieved enables matrix evaporation at a low temperature (80°C), significantly reducing sample contamination and biological degradation during deposition. Additionally, the ability to achieve a linear calibration of deposited matrix layers was demonstrated, allowing for precise control of thickness, essential for optimizing MALDI-MSI experiments. Notably, the LTE method serves as an additional purification step, blocking impurities with shutters during deposition, resulting in very pure matrix layers irrespective of matrix quality. Furthermore, LTE deposition yields homogeneous layers of small-sized matrix crystals (average size: 0.54 µm for DHB and 0.34 µm for DAN) on tissue surfaces. Importantly, the morphology and crystal size of DHB and DAN matrices remain stable when stored at -80°C for at least 2 weeks, with no impact on ionization efficiency or MSI image quality. Current advancements are steering towards single-cell imaging with pixel sizes as small as 1-2µm[2], driven by instrumental progress. The presently disclosed method holds promise in enhancing MSI data quality owing to crystal sizes (< 1 µm), surpassing the pixel size. Comparative analysis with the spray-coating method demonstrates that LTE application of DAN matrix detects a larger number of lipids, exhibits higher signal intensities, reduces analyte diffusion, and improves MSI image quality. Overall, the disclosed method represents a significant advancement in matrix deposition for MALDI-MSI applications, offering enhanced performance and reproducibility.

### Experimental protocol for proof of concept

### Materials and methods

### Reagent and chemicals

Ethanol (HPLC grade) was purchased from Scharlab S.L. 2,5-Dihydroxybenzoic acid (DHB) ≥99.0%, DHB 98%; DAN: 1,5-Diaminonaphthalene (DAN) ≥99.0%, and DAN 97% were purchased from Sigma-Aldrich. Microscope slides were purchased from Epredia and Conductive ITO-coated slides were purchased from Bruker.

### Tissue Sampling

Bovine liver procured from a local butcher shop was stored in a -80°C freezer and subsequently transferred to a +4°C chamber for preparation. The liver was dissected into small pieces and placed in micro-tubes containing three metal beads for homogenization. Homogenization of the liver tissue was achieved using the FastPrep-24 homogenizer (M.P. Biomedicals, Irvine, California, USA) with the speed set to 4 rpm for 15 seconds. Following homogenization, the metal beads were removed, and the micro-tubes were immediately immersed in ice-cold water and subsequently transferred to a -80°C freezer for storage. Brain tissues utilized in this study were harvested from C57BL/6 mice, promptly flash-frozen on dry ice, and stored at -80°C until further processing. Fresh-frozen mouse brain and liver homogenate samples were sectioned at -20°C into 10 µm thick sections using a CryoStar NX50 cryostat. Subsequently, the tissue sections were mounted onto indium tin oxide (ITOcoated) microscope slides and promptly stored in a -80°C freezer for subsequent analysis.

### Development of a matrix deposition method by low thermal evaporation and thickness layer characterization

To carry out the presently disclosed method, the most suitable thermal evaporation device was equipped with two low-temperature evaporation sources featuring shutters and a quartz crystal sensor head. These LTE cells contained crucibles enabling the deposition of volatile materials at temperatures up to 600°C. The chamber was integrated with a turbomolecular pumping system.

Optimization of 2,5-dihydroxybenzoic acid (DHB) and 1,5-Diaminonaphthalene (DAN) deposition was conducted under a vacuum pressure of 5x10⁻³ Pa. The thermal evaporator featured a quartz crystal microbalance sensor for monitoring thickness, relying on parameters such as density and acoustic number of the organic matrices. Density and acoustic number values were set at 1.4 and 0.1, respectively, for both DHB and DAN matrices, as reference data for these parameters were unavailable. Deposition of DHB and DAN matrices involved placing 300 mg of the respective matrix into the crucible within the LTE source. Upon chamber evacuation, the LTE source was heated incrementally from 55°C to 80°C, and the substrate shutters were opened after reaching 80°C to enable deposition of evaporated matrix particles onto the sample slide. Deposition ceased by closing all the shutters upon reaching the targeted matrix layer thickness.

Calibration of DHB and DAN matrix thicknesses against the thickness monitored by the thermal evaporator sensor was conducted using silicon wafer slides for real thickness measurements and glass slides for weight measurements. Calibration points were selected at intervals of 2500 Å for DHB and 2000 Å for DAN, spanning from 5000 Å to 17500 Å for DHB and from 4000 Å to 12000 Å for DAN. Silicon wafers were prepared by cutting into slides of 5x1 cm dimensions, mounted on glass slides, and subsequently placed on the substrate holder of the thermal evaporator. Up to three slides (75x25 cm) could be accommodated on the substrate target, allowing for two replicates of matrix layer deposition on silicon slides and one glass slide sample per experiment. Each calibration point was replicated six times, with three experimental depositions performed on the same day.

Electron microscopy measurements, specifically ESEM analysis (FEI Quanta 600, FELMI-ZFE), were employed to determine the real thickness of the matrix layer deposited on silicon. Following matrix application, the silicon cross sections were observed using ESEM under low vacuum (0.68 Torr) utilizing a Large Field Detector (LFD). To determine the optimal matrix thickness for MALDI imaging of lipids, liver homogenate tissue sections were coated using thermal evaporation with varying DHB and DAN layer thicknesses. Six DHB layer thicknesses ranging from 5000 Å to 17500 Å and five DAN thicknesses from 4000 Å to 12000 Å were assessed.

### Matrix purity analysis

For the analysis of the matrix alone, microscope slides were initially washed with ethanol and allowed to dry. Pure matrices (≥99% purity) of DHB and DAN, as well as non-pure matrices (98% DHB and 97% DAN), were deposited onto the microscope slides using two distinct approaches. The first protocol involved employing the developed thermal evaporation method with controlled source and substrate shutters (referred to as "C_Sh"), while the second deposition was conducted with both shutters left open throughout the evaporation process ("O_Sh").

For comparison experiments between pure matrices and non-pure matrices, sagittal sections (10 pm) of mouse brain tissues were utilized. The pure and non-pure matrices were deposited onto the brain sections using the optimized evaporation method.

### Sample stability analysis

DAN and DHB matrices were deposited onto mouse brain sections using LTE following the optimized method. The coated brain slides were subsequently stored in a -80°C freezer. Sample slides were retrieved for analysis after storage durations of 1 hour, 24 hours, and 14 days prior to conducting MALDI-MSI and ESEM analysis.

### Comparison between LTE and spray-coating

For the LTE samples, sagittal sections of mouse brains were coated with DAN and DHB matrices, subsequently packaged in dry ice and shipped to Germany. Upon arrival, they were promptly stored at -80°C prior to MALDI-MSI analysis. For the spray-coating samples, DHB (40 mg/mL in 70% methanol) and DAN (10 mg/mL in 50% acetonitrile) were sprayed onto the samples using an HTX-M5 sprayer (HTX Technologies, LLC, Chapel Hill, USA). The spray parameters were as follows: For DHB, the temperature was set to 65°C, with 11 passes and a flow rate of 0.05 pL/min; for DAN, the temperature was set to 60°C, with 10 passes and a flow rate of 0.06 pL/min.

### MALDI imaging spectra acquisition

### Two MALDI instruments were used in this study:

A dual-ion funnel MALDI/ESI injector (Spectroglyph, Kennewick, WA) equipped with an Orbitrap Exploris 120 mass spectrometer (Thermo Fisher Scientific) was utilized for MALDI MS imaging analysis, with a spatial step-size of 20 and 30 µm. Spectra were acquired in the m/z mass range of 400 to 1200 Da for MALDI imaging of lipids and from 50 to 600 Da for the analysis of only matrix samples at a mass resolution of 60,000 (FWHM at m/z 200). Processing of MSI datasets, as well as MSI image reconstruction and visualization, were carried out using the rMSI2 R package. The identified MALDI ions were cross-referenced with the Lipid Maps database. A mass tolerance of +/- 0.005 m/z was applied for the search, and [M+H]⁺, [M-H2O+H]⁺, [M+Na]⁺, and [M+K]⁺ adducts were selected for positively detected ions, while [M-H]⁻ adducts were selected for negative ions.

A timsTOFfleX mass spectrometer (Bruker Daltonik, Bremen, Germany), operated in tims OFF mode, was also utilized. The mass range was set between m/z 400 and 1200, with a spatial step-size of 10 and 30 um. Between 50 and 200 laser shots were summed up per pixel for all experiments, with the laser operating at a repetition rate of 10 kHz, except for some exceptions at 5 kHz. All raw data were directly uploaded and processed in SCiLS lab (Version 2023a Pro). The displayed data, including ion images and spectra, were normalized to the root mean square (RMS).

### References

1. Caprioli, R.M.; Farmer, T.B.; Gile, J. Molecular Imaging of Biological Samples: Localization of Peptides and Proteins Using MALDI-TOF MS. Anal. Chem. 1997, 69, 4751-4760.
2. Yang, J.; Caprioli, R. M. Matrix Sublimation/Recrystallization for Imaging Proteins by Mass Spectrometry at High Spatial Resolution. Anal. Chem. 2011, 83, 5728-5734.
3. Sparvero, L. J.; Amoscato, A. A.; Dixon, C. E.; Long, J. B.; Kochanek, P. M.; Pitt, B. R.; Bayir, H.; Kagan, V. E. Mapping of Phospholipids by MALDI Imaging (MALDI-MSI): Realities and Expectations. J. Chem. Phys. Lipids. 2012, 165, 545-562.
4. Römpp, A.; Guenther, S.; Takats, Z.; Spengler, B. Mass spectrometry imaging with high resolution in mass and space (HR 2 MSI) for reliable investigation of drug compound distributions on the cellular level. J. Anal. Bioanal Chem. 2011, 401, 65-73.
5. Khatib-Shahidi, S.; Andersson, M.; Herman, J. L.; Gillespie, T. A.; Caprioli, R. M. Direct Molecular Analysis of Whole-Body Animal Tissue Sections by Imaging MALDI Mass Spectrometry. Anal. Chem. 2006, 78, 6448-6456.
6. Hsieh, Y.; Chen, J.; Korfmacher, W. A. Mapping pharmaceuticals in tissues using MALDI imaging mass spectrometry. Journal of Pharmacological and Toxicological Methods. 2007, 55, 193-200.
7. Hankin, J. A.; Barkley, R. M.; Murphy, R. C. Sublimation as a method of matrix application for mass spectrometric imaging. J. Am. Soc. Mass Spectrom. 2007, 18, 1646-1652.
8. Thomas, A.; Charbonneau, J. L.; Fournaise, E.; Chaurand, P. Sublimation of New Matrix Candidates for High Spatial Resolution Imaging Mass Spectrometry of Lipids: Enhanced Information in Both Positive and Negative Polarities after 1,5-Diaminonapthalene Deposition. Anal. Chem. 2012, 84, 2048-2054.
9. Ly, A.; Schöne, C.; Becker, M.; Rattke, J.; Meding, S.; Aichler, M.; Suckau, D.; Walch, A.; Hauck, S. M.; Ueffing, M.; Ly, A.; Hauck, S. M.; Ueffing, M. High-resolution MALDI mass spectrometric imaging of lipids in the mammalian retina. J. Histochem. Cell Biol. 2015, 143, 453-462.
10. Pour, M. D.; Malmberg, P.; Ewing, A. An investigation on the mechanism of sublimed DHB matrix on molecular ion yields in SIMS imaging of brain tissue. J. Anal. Bioanal Chem. 2016, 408, 3071-3081.
11. Schmidt, F. B.; Heskes, A. M.; Thinagaran, D.; M⌀ller, B. L.; J⌀rgensen, K.; Boughton, B. A. Mass Spectrometry Based Imaging of Labile Glucosides in Plants. Frontiers in Plant Science. 2018, 9.
12. Hayasaka, T.; Goto-Inoue, N.; Masaki, N.; Ikegami, K.; Setou, M. Application of 2,5dihydroxyacetophenone with sublimation provides efficient ionization of lipid species by atmospheric pressure matrix-assisted laser desorption/ionization imaging mass spectrometry. J. Surf. Interface Anal. 2014, 46, 1219-1222.
13. Kaya, I.; Jennische, E.; Lange, S.; Malmberg, P. Dual polarity MALDI imaging mass spectrometry on the same pixel points reveals spatial lipid localizations at high-spatial resolutions in rat small intestine. J. Anal. Methods. 2018, 10, 2428-2435.
14. Jawaid, A.; Koksal, S.; Sharif, S. Cutting Performance and Wear Characteristics of PVD Coated and Uncoated Carbide Tools in Face Milling Inconel 718 Aerospace Alloy. J. Mater. Process. Technol. 2001, 116, 2-9.
15. Baptista, A.; Pinto, G.; Silva, F. J. G.; Ferreira, A. A.; Pinto, A. G.; Sousa, V. F. C. Wear Characterization of Chromium PVD Coatings on Polymeric Substrate for Automotive Optical Components. Coatings. 2021, 11, 555.
16. Rossnagel, S. M. Sputter Deposition for Semiconductor Manufacturing. IBM J. Res. Dev. 1999, 43, 163-179.
17. Dai, Z. R.; Pan, Z. W.; Wang, Z. L. Novel nanostructures of functional oxides synthesized by thermal evaporation. J. Adv. Funct. Mater. 2003, 13, 9-24.
18. Chopra, K. L.; Paulson, P. D.; Dutta, V. Thin-Film Solar Cells: An Overview, Prog. Photovolt: Res. Appl. 2004, 12, 69-92
19. Ràfols, P.; Vilalta, D.; Torres, S.; Calavia, R.; Heijs, B.; McDonnell, L. A.; Brezmes, J.; del Castillo, E.; Yanes, O.; Ramirez, N.; Correig, X. Assessing the potential of sputtered gold nanolayers in mass spectrometry imaging for metabolomics applications. PLoS ONE. 2018, 13*.*
20. Dufresne, M.; Thomas, A.; Breault-Turcot, J.; Masson, J-F.; Chaurand, P. Silver-Assisted Laser Desorption Ionization For High Spatial Resolution Imaging Mass Spectrometry of Olefins from Thin Tissue Sections. Anal. Chem. 2013, 85, 3318-3324.
21. Mattox, D. M. The foundations of Vacuum Coating Technology. W. Andrew, Noyes Publications, UK, USA. 2003, ISBN: 0-8155-1495-6.
22. Fan, H. J.; Scholaz, R.; Dadgar, A.; Krost, A.; Zacharias, M. A low-temperature evaporation route for ZnO nanoneedles and nanosaws. Appl. Phys. A. 2005, 80, 457-460.
23. Du, J.; Chen, X.; Liu, C.; Ni, J.; Hou, G.; Zhao, Y.; Zhang, X. Highly transparent and conductive indium tin oxide thin films for solar cells grown by reactive thermal evaporation at low temperature. Appl. Phys. A. 2014, 117, 815-822.
24. Roche, P.; Glennon, B.; Jones, R. C.; Donnellan, P. Low-temperature evaporation of continuous pharmaceutical process streams in a bubble column. Chemical Engineering Research and Design. 2021, 166, 74-85
25. Caughlin, S.; Park, D. H.; Yeung, K. K.-C.; Cechetto, D. F.; Whitehead, S. N. Sublimation of DAN Matrix for the Detection and Visualization of Gangliosides in Rat Brain Tissue for MALDI Imaging Mass Spectrometry. J. Vis. Exp. 2017, 121, 55254.
26. Sadeghi, M.; Vertes, A. Crystallite size dependence of volatilization in matrix-assisted laser desorption ionization. Applied Surface Science. 1998, 127-129, 226-234
27. Niehaus, M.; Soltwisch, J.; Belov, M.E.; Dreisewerd, K. Transmission-mode MALDI-2 mass spectrometry imaging of cells and tissues at subcellular resolution. Nat Methods. 2019, 16, 925-931.
28. Kompauer, M.; Heiles, S.; Spengler, B. Atmospheric pressure MALDI mass spectrometry imaging of tissues and cells at 1.4-um lateral resolution. Nat Methods. 2017, 14, 90-96.
29. Allen Mouse Brain Atlas https://mouse.brain-map.org/ (2004).

This description is of course not in any way restricted to the forms of implementation presented herein and any person with an average knowledge of the area can provide many possibilities for modification thereof without departing from the general idea as defined by the claims. The preferred forms of implementation described above can obviously be combined with each other. The following claims further define the preferred forms of implementation.

## Claims

1. A method of preparing a biological sample by low-temperature thermal evaporation suitable for MALDI-MSI analysis comprising the following steps:
- Providing a biological sample;
- Providing an organic matrix compound in the form of a powder;
- Providing a pressure condition between 5x10⁻³ and 5x10⁻⁵ Pa;
- Providing a temperature condition by heating the organic matrix compound at a temperature between 50°C and 60°C, and increasing the temperature in 5°C, or 2°C, or 1°C increments until reaching the evaporation temperature of the matrix compound at the set pressure;
- Waiting for at least 2 minutes for deposition rate stabilization;
- Rotating the biological sample to allow the deposition of at least one matrix layer on the surface of the sample;
- Monitoring the thickness of the deposited matrix compound layer on the biological sample until the desired thickness is achieved;
- Collecting the biological sample with at least one organic matrix layer suitable for MALDI-MSI analysis.

2. The method according to the previous claim, wherein the organic matrix compound is selected from 2,5-dihydroxybenzoic acid, 1,5-Diaminonaphthalene, 9-Aminoacridine, α-Cyano-4-hydroxycinnamic acid, Sinapinic acid or α-Cyano-4-hydroxycinnamic acid and Aniline.

3. The method according to any of the previous claims, wherein it is carried out in a thermal evaporation device suitable for the deposition of volatile compounds up to 600°C, the device comprising a rotary sample holder, at least one low thermal evaporation source, at least one source shutter, at least one substrate shutter, at least one quartz crystal thickness sensor.

4. The method according to the previous claim, wherein the source and substrate shutters of the device are closed during the temperature increasing phase of the method.

5. The method according to any of the claims 3 to 4, wherein after the evaporation temperature of the organic matrix compound is reached, the source and substrate shutters of the device are opened.
